# EUROPEAN PATENT APPLICATION

(11) **EP 4 401 513 A1**
(43) Date of publication of application: **17.07.2024**
(21) Application number: 22867714.2
(22) Date of filing: 07.09.2022
(51) Int. Cl.: H05G 2/00, G03F 7/20

(54) **ELECTRON BEAM-BASED EXTREME ULTRAVIOLET LIGHT SOURCE DEVICE**

(30) Priority: 10.09.2021 KR 20210121129
(71) Applicant: UNIVERSITY-INDUSTRY COOPERATION GROUP OF KYUNG HEE UNIVERSITY, Yongin-si, Gyeonggi-do 17104 (KR)
(72) Inventor: PARK, Kyu Chang, Seoul 06269 (KR); YOO, Sung Tae, Yongin-si Gyeonggi-do 17103 (KR)
(74) Representative: Isarpatent
(86) International application number: PCT/KR2022/013482
(87) International publication number: WO 2023/038446

(57) **Abstract**

There is provided a light source device according to one embodiment of the present disclosure for outputting an extreme ultraviolet light source based on an electron beam, comprising: a chamber; an electron beam emission unit including a cathode electrode and a plurality of emitters, each of which contains a carbon-based material and which are arranged over the cathode electrode in such a manner as to be spaced apart from each other, the electron beam emission unit generating an electron beam within the chamber; and an anode electrode positioned within the chamber, but in a manner that is spaced apart from the electron beam emission unit, and ionized upon incidence of the electron beam thereon, thereby generating plasma, wherein extreme ultraviolet is generated from the plasma.

## Description

### Technical Field

The present disclosure relates to an electron beambased extreme ultraviolet light source device, and more particularly, to an apparatus for outputting extreme ultraviolet light source using an electron beam.

### Background Art

Extreme ultraviolet (EUV) is an electromagnetic wave with a wavelength ranging approximately from 10 nm to 100 nm, falling between X-ray and deep ultraviolet (DUV). In recent years, a lot of research has been focused on the development of compact extreme ultraviolet light source devices for applications dealing with extreme ultraviolet field.

For example, extreme ultraviolet lithography equipment is being used in nanometer-scale micropatterning process for semiconductor manufacturing. However, current extreme ultraviolet lithography equipment is based on high-power lasers and is only released as products from a specific overseas company. In particular, since this extreme ultraviolet lithography equipment is laser-based, it is very expensive, has a complex internal structure, occupies a large volume, and is difficult to maintain due to the large amounts of debris generated by the laser, which is bound to be very high power depending on its output characteristics.

### Disclosure

### Technical Problem

One object of the present disclosure, which is made to address the above-mentioned problem in the prior art, is to provide an extreme ultraviolet light source technology that has a simple internal structure, a compact size, and can lower manufacturing costs.

Another object of the present disclosure is to provide an extreme ultraviolet light source technology that is advantageous for maintenance by reducing debris by using a low-power electron beam compared to a laser.

Still another object of the present disclosure is to provide an extreme ultraviolet light source technology that utilizes a plurality of electron beams and anode structures in a more efficient manner, resulting in improved light output.

However, the present disclosure is not limited to the above-mentioned objects. From the following description, other objects not mentioned would be readily understandable to a person of ordinary skill in the art to which the present disclosure pertains.

### Technical Solution

In order to address the above-mentioned objects, there is provided a light source device according to one embodiment of the present disclosure for outputting an extreme ultraviolet light source based on an electron beam, comprising: a chamber; an electron beam emission unit including a cathode electrode and a plurality of emitters, each of which contains a carbon-based material and which are arranged over the cathode electrode in such a manner as to be spaced apart from each other, the electron beam emission unit generating an electron beam within the chamber; and an anode electrode positioned within the chamber, but in a manner that is spaced apart from the electron beam emission unit, and ionized upon incidence of the electron beam thereon, thereby generating plasma, wherein extreme ultraviolet is generated from the plasma.

The anode electrode may contain a metal radiative material on its surface that generates the plasma.

The metal radiative material may contain one or more selected from the group consisting of Sn, Li, In, Sb, Te, Tb, Gd, and Al.

A plurality of said electron beam emission units are provided, and the electron beams generated by the plurality of the electron beam units are incident at different locations on the at least one anode electrode, wherein each of the electron beams may be incident one by one or a plurality of electron beams may be incident simultaneously.

At least two of the electron beams may be incident at different angles or in different directions.

At least two of the electron beams may be incident at different angles, but at different intensities.

The first electron beam having a large incident angle may have a higher intensity than the second electron beam having a small incident angle.

The device may further include a rotation plate rotating within the chamber, wherein the anode electrode may have the shape of a circular plate or a ring and may be positioned on the rotation plate, thereby rotating by the rotation plate.

In the device, a multiplicity of the electron beam emission units may be provided, and a multiplicity of the anode electrodes having different diameters may be provided, each of which has a ring shape spaced apart from each other in the inside thereof, and electron beams generated in the multiplicity of the electron beam emission units may be incident one by one on the multiplicity of the anode electrodes.

The anode electrode may have the shape of a cone or a truncated cone, and the electron beams may be incident at different positions on a lateral surface of the anode electrode in the shape of a cone or a truncated cone.

The device may further include a support body provided within the chamber in such a manner as to support the anode electrode, wherein a structure including the anode electrode and the support body may have the shape of a cone or a truncated cone, and a multiplicity of the anode electrodes may be arranged, in the shape of rings, to be spaced apart from each other on a lateral surface of the structure in the shape of a cone or a truncated cone, and wherein each of the electron beams may be incident at different positions on each of the anode electrodes in the shape of rings.

The anode electrode may rotate about the central axis of the shape of a cone or a truncated cone.

A multiplicity of extreme ultraviolet light sources generated by each of the electron beams may proceed in a direction in which the vertex of the anode electrode in the shape of a cone faces straight or may proceed in a direction in which an upper surface of the anode electrode in the shape of a truncated cone faces straight.

A support body in the shape of an arch, which supports the anode electrode, and a reflection layer, which reflects the extreme ultraviolet, may be further included within the chamber, and a multiplicity of the anode electrodes may be arranged on the support body in the shape of an arch, in such a manner as to be spaced apart from each other, and the reflection layers may be arranged on both sides, respectively, of each of the anode electrodes.

The light source device according to one embodiment of the present disclosure may further include a light collecting electrode in the shape of a ring provided within the chamber and serving for intermediate focus (IF) of a multiplicity of extreme ultraviolet light sources that are generated by the electron beams and pass through the opening of the light collecting electrode.

The electron beam emission unit may further include a gate electrode positioned over the plurality of emitters in a manner that is spaced apart from the plurality of emitters, and a portion, facing the plurality of emitters, of the gate electrode may have a mesh structure of a conductive material.

The electron beam emission unit may further include at least one focusing electrode positioned over the gate electrode in a manner that is spaced apart from the gate electrode, which focusing the electron beams by a negative voltage being applied to the gate electrode.

The focusing electrode includes a first focusing electrode and a second focusing electrode arranged over the first focusing electrode in a manner that is spaced apart from the first focusing electrode. The first and second focusing electrodes may have respective openings facing each other, in such a manner as to allow the electron beams to pass through, and the opening in the second focusing electrode may be smaller than the opening in the first focusing electrode.

### Advantageous Effects

According to the present disclosure, with the configuration as described above, extreme ultraviolet (EUV) light source is generated based on an electron beam but using a common anode electrode separately from an electron beam emission unit. Therefore, the present disclosure provides the advantage of achieving a simple inner structure, a compact size, and a low manufacturing cost.

In addition, the present disclosure has the advantage of reducing the adverse effects on the anode electrode by utilizing an electron beam with a lower power compared to a laser, thereby reducing debris and the like, which is advantageous for maintenance, and has the effect of increasing the amount of extreme ultraviolet light through a plurality of electron beams and various structures of the anode electrode.

In addition, the present disclosure provides the advantage of more efficiently utilizing a multiplicity of electron beams by adjusting their intensities according to the angles of incidence of the multiplicity of electron beams.

The present disclosure is not limited to the above-mentioned effects. From the following description, other effects not mentioned would be readily understandable to a person of ordinary skill in the art to which the present disclosure pertains.

### Description of Drawings

FIG. 1 is a view illustrating a configuration of an extreme ultraviolet light source device 10 according to an embodiment of the present disclosure.
FIG. 2 is a view illustrating a detailed configuration of an electron beam emission unit 200.
FIGS. 3(a) and 3(b) are a perspective view and a cross-sectional view, respectively, illustrating an example of the electron beam emission unit 200.
FIG. 4 is a cross-sectional view illustrating another example of the electron beam emission unit 200, which results from adding focusing electrodes 251, 252 to the example in FIGS. 3(a) and 3(b).
FIGS. 5 to 11 are views illustrating various examples of anode electrodes 300.
FIG. 12 is a conceptual diagram showing an experiment for identifying an influence of an incident angle of an electron beam on the anode electrode 300.
FIGS. 13 and 14 show the results of the experiment in FIG. 12.
FIGS. 15 to 18 are views illustrating various embodiments in cases where light collecting electrodes (520) are provided.

### [Description of the Reference Numerals in the Drawings]

10: Extreme ultraviolet light source device
100: Chamber
110: Exit 200: Electron beam emission unit
210: Cathode electrode 220: Electric field emission substrate
230: Emitter 240: Gate electrode
241: Mesh structure 242: Support body
251, 252: focusing electrodes 261, 262, 263: Insulation layer
300, 300a, 300b, 300c, 300d, 300e, 300f: Anode electrodes
410, 430: Support body 420: Rotation plate
510: Reflection layer 520: light collecting electrode

### Best Mode

The objects of the present disclosure, the means of achieving the objects thereof, and the advantageous effects thereof will be apparent from the following detailed description, which is provided with reference to the accompanying drawings in sufficient detail to enable a person having ordinary skill in the art to which the present disclosure pertains to practice the present disclosure. In addition, in a case where it is determined that a specific description of a known art related to the present disclosure would unnecessarily obscure the nature and gist of the present disclosure, the detailed description thereof is omitted from description of the present disclosure.

Unless otherwise defined, all terms used in the present disclosure should be construed as having meanings commonly understandable to a person having ordinary skill in the art to which the present disclosure pertains. In addition, unless otherwise explicitly and specifically defined, the terms as defined in commonly used dictionaries should not be construed ideally or excessively.

Preferred embodiments of the present disclosure will be described in detail below with reference to the accompanying drawings.

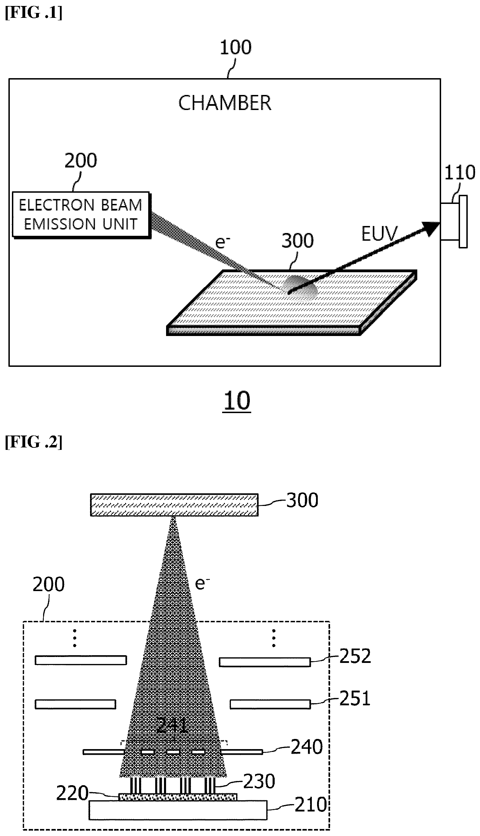

FIG. 1 is a view illustrating a configuration of an extreme ultraviolet light source device 10 according to an embodiment of the present disclosure.

With reference to FIG. 1, the extreme ultraviolet light source device 10 according to the embodiment of the present disclosure includes a chamber 100, an electron beam emission unit 200 positioned within the chamber 100, and an anode electrode 300. The anode electrode 300 here may be configured to contain one or more metal selected from the group consisting of Sn, Li, In, Sb, Te, Tb, Gd, and Al. For example, the extreme ultraviolet light source device 10 may be used as a lithography apparatus during a micropatterning process for manufacturing semiconductors, but is not limited thereto.

The chamber 100 is kept under vacuum inside and keeps plasma inside. Such plasma is generated by ionization of the anode electrode 300 upon incidence of an electron beam thereon. For convenience, a region of a space within the chamber 100, where plasma is kept, is referred to as a "plasma region." The chamber 100 may include an exit 110 through which extreme ultraviolet (EUV) light source, which occurs in the plasma region, is outputted.

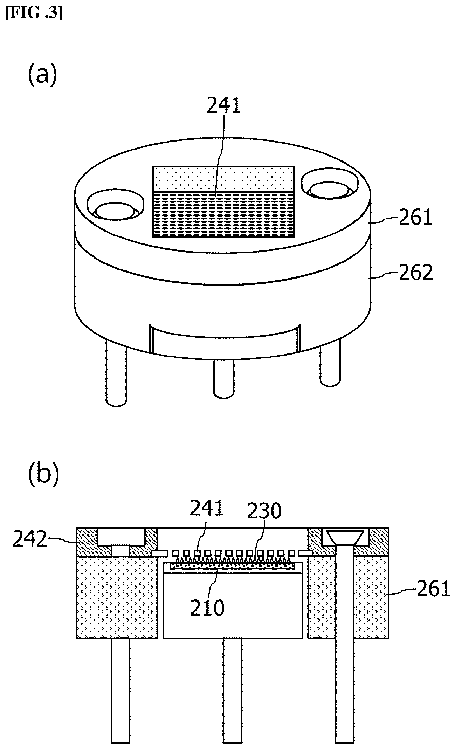

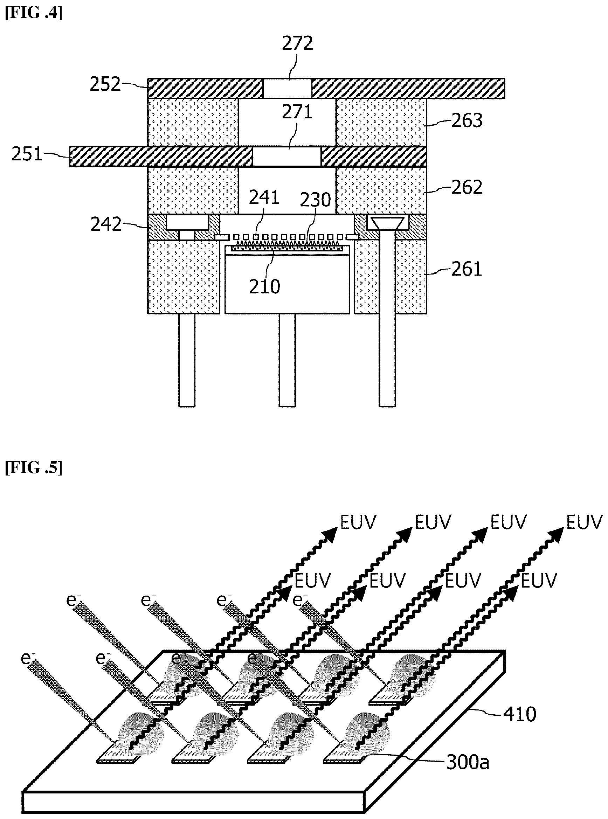

FIG. 2 is a view illustrating a detailed configuration of the electron beam emission unit 200. In addition, FIGS. 3(a) and 3(b) are a perspective view and a cross-sectional view, respectively, illustrating an example of the electron beam emission unit 200. FIG. 4 is a cross-sectional view illustrating another example of the electron beam emission unit 200, which results from adding focusing electrodes 251, 252 to the example in FIGS. 3(a) and 3(b).

The electron beam emission unit 200 is configured to generate and emit an electron beam e⁻. At this point, the electron beam emission unit 200 is based on a carbon-based emitter 230 that emits electrons by an electric field, instead of being based on a laser.

The electron beam emission unit 200 is positioned within the chamber 100 and irradiates an electron beam toward the anode electrode 300 that is arranged to be spaced apart from the electron beam emission unit 200 within the chamber 100. With reference to FIGS. 2 to 4, the electron beam emission unit 200 includes a cathode electrode 210, a plurality of emitters 230 positioned over the cathode electrode 210, and a gate electrode 240 positioned over the plurality of emitters 230 in a manner that is spaced apart from the plurality of emitters 230.

The cathode electrode 210 and the anode electrode 300 contain a conductive material, and, normally, are used as a negative electrode and a positive electrode, respectively. For example, the cathode electrode 210 and the anode electrode 300 each may contain a metal, such as Al, Au, Ni, Ti, or Cr; transparent conductive oxide (TCO), such as indium tin oxide (ITO), indium zinc oxide (IZO), aluminum zinc oxide (AZO), or indium zinc tin oxide (IZTO; a conductive polymer; graphene; or similar material, but are not limited thereto.

In the prior art, in normal cases, a cathode electrode, an emitter, and an anode electrode are provided together within an electron beam emission unit. In these cases, the electron beam emission unit may become large in volume. In contrast, according to the present disclosure, the anode electrode 300 is not provided within the electron beam emission unit 200. Instead, the anode electrode 300 is configured to be separately provided in a manner that is spaced apart from the electron beam emission unit 200 within the chamber 100. Accordingly, the present disclosure provides the advantage that, although a multiplicity of electron beam emission units 200 are provided, the total volume thereof can be reduced.

In addition, according to the present disclosure, the multiplicity of electron beam emission units 200 can emit electron beams using a common anode electrode 300 separately provided within the chamber 100. Therefore, the present disclosure provides the advantage of achieving a simpler inner structure, a more compact size, and a lower manufacturing cost than in a case where a cathode electrode, an emitter, and an anode electrode are provided together within an electron beam emission unit.

The plurality of emitters 230 are configured to emit electrons, supplied from the cathode electrode 210, toward the anode electrode 300. The emitter 230 may be configured as a pointed emitter tip or as a flat emitter layer. At this point, in addition to the acicular shape, the emitter tip may be formed in various shapes, such as a horn and a triangular pyramid. For example, the emitters 230 may be arranged on the cathode electrode 210 in such a manner as to be a predetermined distance apart from each other in the longitudinal direction and the traverse direction.

The emitter 230 may contain a carbon-based material. Examples of the carbon-based material may include carbon nanotubes (CNTs), carbon nanowires, semiconductor nanowires, zinc oxide nanowires, carbon nanofibers, conductive nanorods, graphite, nanographene, and similar materials, but are not limited thereto.

However, in a case where the emitter 230 is realized as a carbon nanotube, the emitter 230 can obtain high-efficiency electric field emission properties unique to the carbon nanotube. For example, this carbon nanotube emitter 230 may be formed using various processes, such as laser vaporization, arc discharge, thermal-CVD, plasma-CVD, hot filament chemical vapor deposition (HF-CVD), but are not limited thereto.

Meanwhile, the emitter 230 may be provided on top of an electric field emission substrate 220. In this case, the electric field emission substrate 220 may be a normal wafer provided in such a manner that an electric field emission element includes an emitter. That is, the electric field emission substrate 220 is formed on top of the cathode electrode 210, and thus, the emitter 230 is mounted on the electric field emission substrate 220.

The gate electrode 240 is configured to regulate the flow of electrons, emitted from the emitter 230, according to a voltage being input. A portion, facing the plurality of emitters 230, of the gate electrode 240, that is, a portion, opposite the plurality of emitters 230, of the gate electrode 240, may include a mesh structure 241 with a conductive material (for example, a metal or the like). For example, the mesh structure 241 may employ a configuration in which thin metal wires are woven into a net shape in such a manner as to be spaced a distance apart from each other, or may employ a configuration in which a plurality of openings are formed in a metal plate. The gate electrode 240 may diffuse the electrons emitted from the emitter 230 while allowing the electron beam to pass through spaces between the metal lines in the mesh structure 241 or through the plurality of openings.

The gate electrode 240 contains a conductive material. For example, the gate electrode 240 may contain a metal, such as Al, Au, Ni, Ti, or Cr; transparent conductive oxide (TCO), such as indium tin oxide (ITO), indium zinc oxide (IZO), aluminum zinc oxide (AZO), or indium zinc tin oxide (IZTO); a conductive polymer; graphene; or similar material, but is not limited thereto.

An insulation layer (or an insulation spacer), which is not illustrated, may be positioned between the cathode electrode 210 and the gate electrode 240 around the plurality of emitters 230. At this point, the insulation layer is formed to have a thickness greater than a height of each of the plurality of emitters 230 in such a manner that the gate electrode 240 does not contact the plurality of emitters 230. The insulation layer can keep the gate electrode 240 insulated from the cathode electrode 210 and the plurality of emitters 230.

A low voltage (a negative voltage) is applied to the cathode electrode 210, or the cathode electrode 210 is connected to the ground. A high voltage (a positive voltage) of 5 kV or more may be applied to the anode electrode 300. In addition, a pulse voltage may be applied to the gate electrode 240. That is, a difference in voltage between the cathode electrode 210 and the gate electrode 240 forms an electric field around the plurality of emitters 230. This electric field causes the plurality of emitters 230 to emit electron beams. The emitted electron beams are accelerated by being attracted to the high voltage of the anode electrode 300.

At this point, the pulse voltage of the gate electrode 240 is a voltage having a high frequency or a low pulse width. For example, the pulse voltage may have characteristics of a high frequency of 100 kHz or higher. This pulse voltage makes high-speed switching of an electron beam possible and results in achieving an effect of lowering drive electric power.

As illustrated in FIGS. 3(a) and 3(b), the electron beam emission unit 200 may be formed without focusing electrodes 251, 252, or as illustrated in FIG. 4, the electron beam emission unit 200 may be formed to include at least one or more focusing electrodes 251, 252, which is arranged over the gate electrode 240 in a manner that is spaced apart therefrom. For example, the first focusing electrode 251, which is arranged over the gate electrode 240 in a manner that is spaced apart therefrom, and the second focusing electrode 252, which is arranged over the first focusing electrode 251 in a manner that is spaced apart therefrom, may be provided.

The electron beam emission unit 200 may include a support body 242. The support body 242 is fixed to an edge of the mesh structure 241 corresponding to the plurality of emitters 230 and thus supports the mesh structure 241. In addition, a first insulation layer 261 may be positioned between the cathode electrode 210 and the support body 242 around the plurality of emitters 230.

The positioning of a second insulation layer 262 between the gate electrode 240 and the first focusing electrode 251 can insulate the gate electrode 240 and the first focusing electrode 251 from each other. The positioning of a third insulation layer 263 between the first focusing electrode 251 and the second focusing electrode 252 can insulate the first focusing electrode 251 and the second focusing electrode 252 from each other. Of course, the positioning of a fourth insulation layer (not illustrated) on top of the second focusing electrode 252 may insulate an upper portion of the second focusing electrode 252.

The second insulation layer 262, the first focusing electrode 251, the third insulation layer 263, the second focusing electrode 252, and the fourth insulation layer (not illustrated) have respective openings for allowing an electron beam to pass through. At this point, the second insulation layer 262 and the third insulation layer 263 may be formed to have the openings of the same size.

An opening 271 in the first focusing electrode 251 may be smaller in diameter than the entire mesh structure 241 of the gate electrode 240. An opening 272 in the second focusing electrode 252 may be smaller in diameter than the opening 271 in the first focusing electrode 251. Of course, an additional focusing electrode (not illustrated) may be provided over the second focusing electrode 252 in a manner that is spaced apart therefrom. In this case, an opening in the additional focusing electrode may be smaller in diameter than the opening 272 in the second focusing electrode 252. That is, the openings in the first focusing electrode 251 and the second focusing electrode 252 in this order (that is, in order in the upward direction) may be formed to gradually decrease in diameter.

A negative (minus) voltage may be applied to the first and second focusing electrodes 251 and 252. Accordingly, an electron beam passing through the mesh structure 241 of the gate electrode 240 passes through the opening 271 in the first focusing electrode 251 and then the opening 272 in the second focusing electrode 252. Thus, the electron beam can be concentrated by repulsive forces applied by the first and second focusing electrodes 251 and 252.

With this structure, the electron beam emission unit 200 has the advantage of having a simple inner structure, a compact size, and a low manufacturing cost. This advantage may be further distinct because the anode electrode 300, unlike in the prior art, is separately provided within the chamber 100.

That is, the electron beam emission unit 200, including the first and second focusing electrodes 251 and 252, can focus an electron beam and can reduce the size of the electron beam that is to reach the anode electrode 300. As a result, less metal debris can be generated, thereby lengthening the usage lifetime of the anode electrode 300.

FIGS. 5 to 11 are views illustrating various examples of the anode electrode 300. Of course, in various examples of the anode electrodes 300, each of the anode electrodes 300a through 300f is provided within the chamber 100 in a manner that is separated from the electron beam emission unit 200.

An electron beam that is emitted from the electron beam emission unit 200 and is accelerated toward the anode electrode 300 is incident on (directed toward) the anode electrode 300. The incidence of the electron beam ionizes an electron beam-incident region of the anode electrode 300, thereby generating plasma, and extreme ultraviolet (EUV) is generated in that plasma region surrounding the anode electrode 300. That is, the plasma generated by the electron beam from the anode electrode 300 functions as a light source generating extreme ultraviolet (EUV). The extreme ultraviolet (EUV) generated in this manner can be output outside the chamber 100 through the exit 110 in the chamber 100.

In this case, the anode electrode 300 may contain a metal radiative material that generates plasma when an electron beam is incident. This metal radiative material may be patterned in various shapes in a manner that corresponds to a surface of the anode electrode 300. For example, the metal radiative material may contain one or more metal selected from the group consisting of Sn, Li, In, Sb, Te, Tb, Gd, and Al.

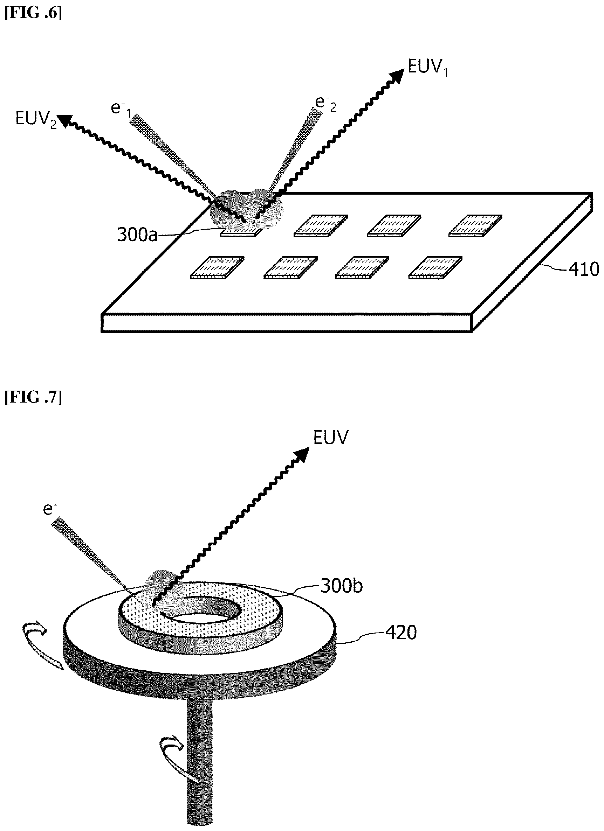

With reference to FIGS. 5 and 6, the multiplicity of electron beam emission units 200 may be provided. At this point, respective electron beams generated in the multiplicity of electron beam emission units 200 may be incident on at least one anode electrode 300 at the same position or different positions, or in the same direction or different directions.

That is, the multiplicity of electron beam emission units 200 may generate electron beams one after another in response to pulse drive by a gate voltage applied to each gate electrode 240. Alternatively, the multiplicity of electron beam emission units 200 may simultaneously generate electron beams according to pulse drive by a gate voltage applied to each gate electrode 240. In this case, for example, a control unit (not illustrated) may control the multiplicity of electron beam emission units 200 in such a manner that they generate electron beams in respective turns or simultaneously generate a plurality of electron beams, thereby being incident on the anode electrode 300. Accordingly, each of the electron beams generated in a multiplicity of electron beam emission units 200 may be incident one by one on the anode electrode 300. Alternatively, a plurality of electron beams may be simultaneously incident on the anode electrode 300.

For example, as a first embodiment, as illustrated in FIG. 5, a multiplicity of anode electrodes 300a may be arranged on top of a support body 410 supporting them, in such a manner as to be spaced apart from each other. Of course, the support body 410 is provided within the chamber 100. In this case, as many electron beam emission units 200 as the anode electrode 300a may be provided. In this case, electron beams emitted from the electron beam emission units 200 may be incident, in a dedicated manner, on the anode electrode 300a, respectively. Of course, the electron beam emission units 200, in respective turns, may cause electron beams to be incident on their respective dedicated anode electrodes 300a. Alternatively, a multiplicity of the electron beam emission units 200 may simultaneously cause electron beams to be incident on their respective dedicated anode electrodes 300a.

In addition, the electron beam emission unit 200 that is outnumbered by the anode electrodes 300a may be provided. In this case, at least one electron beam emission unit 200 operates with respect to a plurality of anode electrodes 300a in a dedicated manner. To this end, a motion means for moving or rotating this electron beam emission unit 200 may be further included.

On the other hand, as illustrated in FIG. 6, at least two electron beams e⁻₁ and e⁻₂ may be incident on one anode electrode 300a at different angles or in different directions. At this point, the two electron beams e⁻₁ and e⁻₂ may be emitted from different electron beam emission units 200 and may be incident one by one or simultaneously on the anode electrode 300a. EUV₁ and EUV₂, which are generated by the two electron beams e⁻₁ and e⁻₂, may be output in different angles or at different directions.

Next, as a second embodiment, as illustrated in FIG. 7, a rotation plate 420 that rotates within the chamber 100 and supports an anode electrode 300b may be provided. In this case, the anode electrode 300b is formed in the shape of a circular plate or a ring and is positioned on an upper surface of the rotation plate 420. A rotational axis of the rotation plate 420 corresponds to the center of the shape of a circular plate or a ring. That is, as the rotation plate 420 rotates by driving of a motor (not illustrated) or the like, so does the anode electrode 300b about the center of the shape of a circular plate or a ring.

At this point, at least one electron beam can be incident on one side of a lateral or upper surface of the rotation plate 420 in the shape of a circular plate or a ring. Accordingly, the rotation of the anode electrode 300b continuously varies an electron beam-incident portion of the anode electrode 300b, thereby generating EUV. As a result, in the case of the second embodiment, the electron beam-incident portion of the anode electrode 300b continuously varies. Accordingly, an adverse influence of an electron beam on the anode electrode 300 may be reduced than in a case where an electron beam is continuously incident on only one portion of the anode electrode 300. Thus, the advantage of reducing the generation of debris or the like and lengthening replacement intervals of the anode electrode 300 is provided (this advantage is referred to as an "advantage of the second embodiment").

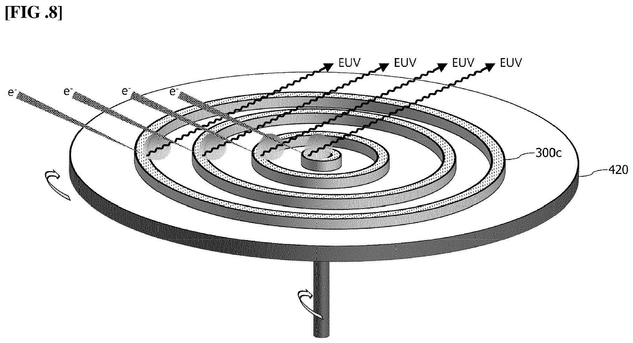

Next, as a third embodiment, as illustrated in FIG. 8, a multiplicity of anode electrodes 300c in the shapes of rings are provided. That is, the multiplicity of anode electrodes 300c having different diameters are provided and arranged to be spaced apart from each other in the inside thereof. Of course, as in the second embodiment, the anode electrodes 300c are positioned on the upper surface of the rotation plate 420. The rotational axis of the rotation plate 420 corresponds to the center of each of the anode electrodes 300c in the shape of rings. That is, as the rotation plate 420 rotates by driving of a motor (not illustrated) or the like, so does each of the anode electrodes 300c about the center of the shape of a ring.

Of course, the multiplicity of electron beam emission units 200 may be provided and each of electron beam emission units 200 may operate in such a manner as to emit electron beams dedicated to each of the anode electrodes 300c, respectively. That is, each of the electron beams generated in the multiplicity of electron beam emission units 200 may be incident one by one or a multiplicity of the electron beams may be simultaneously incident on respective dedicated anode electrodes 300c.

In addition to the advantages of the second embodiment, the third embodiment provides the advantage of not only increasing an amount of light by outputting EUV based on a multiplicity of electron beams, but also outputting EUV having various angles or directions.

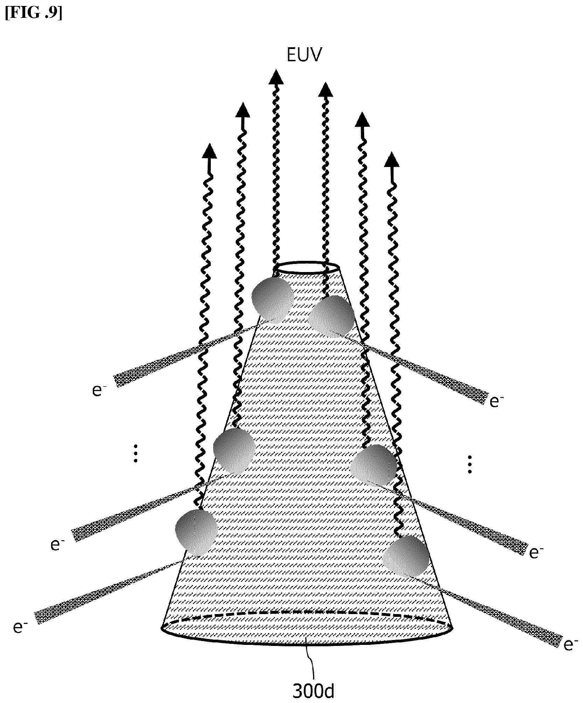

Next, as a fourth embodiment, as illustrated in FIG. 9, an anode electrode 300d is formed in the shape of a cone or a truncated cone. In this case, each of the electron beams generated in the multiplicity of electron beam emission units 200 is incident on a lateral surface of the anode electrode 300d in the shape of a cone or a truncated cone. Of course, each of the electron beams may be incident at different positions on a lateral surface of the anode electrode 300d in the shape of a cone or a truncated cone.

In this case, due to shape characteristic of the anode electrode 300d, a multiplicity of EUV generated by each of the electron beams may proceed in a direction in which the vertex of the anode electrode 300d in the shape of a cone faces straight or may proceed in a direction in which an upper surface of the anode electrode 300d in the shape of a truncated cone faces straight. Of course, each of the electron beams may be incident one by one at different positions on the anode electrode 300d. Alternatively, a multiplicity of electron beams may be simultaneously incident at different positions on the anode electrode 300d.

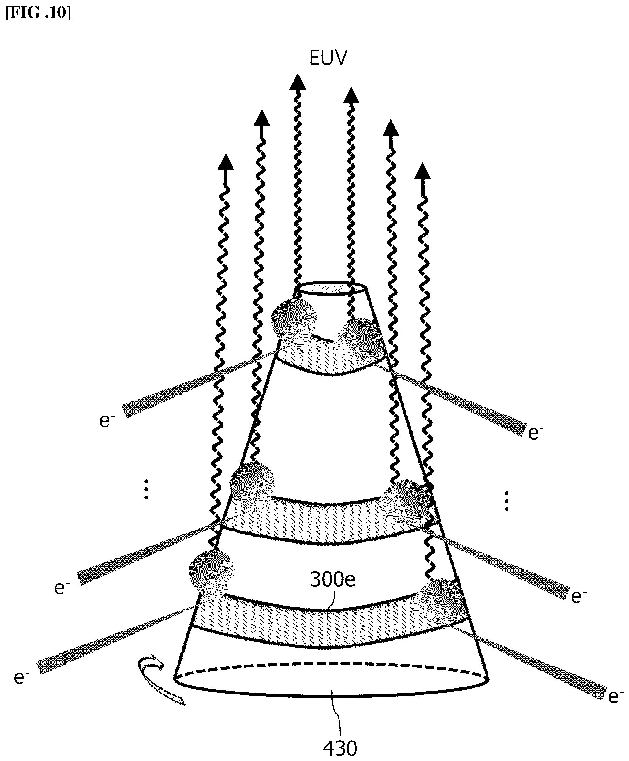

Next, as a fifth embodiment, as illustrated in FIG. 10, a support body 430 is provided within the chamber 100 in such a manner as to support an anode electrode 300e. In this case, a structure (hereinafter referred to as a "complex structure") including the anode electrode 300e and the support body 430 may be formed in the shape of a cone or a truncated cone. That is, a multiplicity of anode electrodes 300e are formed in the shape of a ring and are arranged to be spaced apart from each other on a lateral surface of the complex structure in the shape of a cone or a truncated cone. In this case, each of the electron beams may be incident at different positions on the anode electrode 300e. That is, each of the electron beams may be incident on respective dedicated anode electrodes 300e. Alternatively, a multiplicity of electron beams may be incident at different positions on one anode electrode 300e. Of course, each of the electron beams may be incident one by one, or a multiplicity of electron beams may be simultaneously incident.

In this case, due to shape characteristic of the complex structure, a multiple of EUV generated by the incidence of each of the electron beams may proceed in a direction in which the vertex of the complex structure in the shape of a cone faces straight or may proceed in a direction in which an upper surface of the complex structure in the shape of a truncated cone faces straight.

Meanwhile, in the fourth or fifth embodiment, the anode electrode 300d or the complex structure may rotate about the central axis of the shape of a cone or a truncated cone by driving of a motor (not illustrated) or the like. That is, the central axis of the anode electrode 300d or the complex structure in the shape of a cone may correspond to a line connecting the center of the base side thereof and the vertex thereof. In addition, the central axis of the shape of a truncated cone may correspond to a line connecting the center of the upper side thereof and the center of the base side. However, this rotation about the central axis is illustrated only in the fifth embodiment in FIG. 10, but the present disclosure is not limited thereto. In a case where the rotation about the central axis is possible, the fourth or fifth embodiment can have the same advantage as the second embodiment described above.

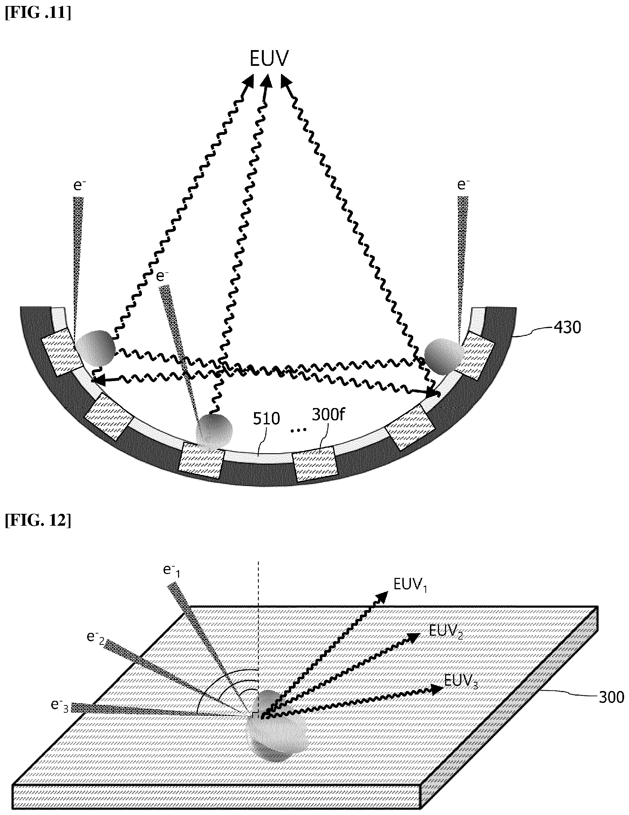

Next, as a sixth embodiment, as illustrated in FIG. 11, a support body 430 in the shape of an arch, which supports an anode electrode 300f, and a reflection layer 510, which reflects EUV, may be provided within the chamber 100. In this case, a multiplicity of anode electrodes 300f may be arranged along the support body 430 in the shape of an arch in such a manner as to be spaced apart from each other.

That is, EUV on any anode electrode 300f, which is generated by the incidence of any electron beam, may be output to the exit 110 in the chamber 100 after being reflected at least one time by the reflection layer 510, without being output directly to the exit 110 in the chamber 100. The application of this reflection function to the anode electrode 300f in the shape of an arch can focus each EUV, generated by the multiplicity of electron beams, toward a specific position on the chamber 100 or toward the exit 110 in the chamber 100. Accordingly, the amount and intensity of the EUV passing through the exit 110 can be increased.

To facilitate the smooth performing of this reflection function, it is preferred that the reflection layer 510 are arranged around or on both sides of each of the anode electrodes 300f. In this case, the reflection layer 510 has a concave reflection surface in the direction toward a specific position on the chamber 100 or toward the exit 110. For example, a multi-layer, formed by alternately stacking molybdenum (Mo) and silicon (Si), may be used as the reflection layer 510, but the reflection layer 510 is not limited thereto.

For example, a structure including the support body 430 in the shape of an arch, the anode electrode 300f, and the reflection layer 510 may be arranged on the other side of the chamber 100. Accordingly, the electron beam emission unit 200 may emit electron beams to the anode electrodes 300f, respectively, in the direction from one side of the chamber 100 to the other side of the chamber 100. A multiplicity of the emitted electron beams are incident on a multiplicity of anode electrodes 300f, respectively, thereby generating a multiplicity of EUV. Subsequently, the generated each EUV may be directly focused in the direction toward a specific position or the exit 110 in the chamber 100. Alternatively, the generated each EUV radiation may be at least one time reflected from the reflection layer 510 and may be focused toward a specific position within the chamber 100 or toward the exit 110 in the chamber 100.

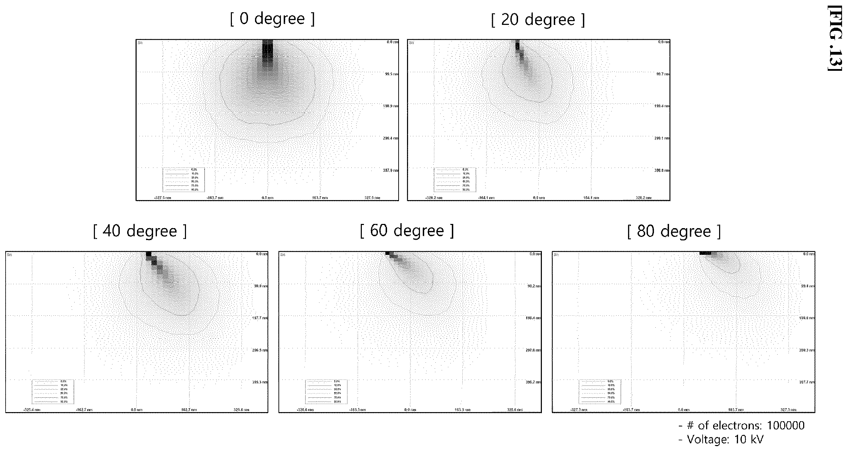

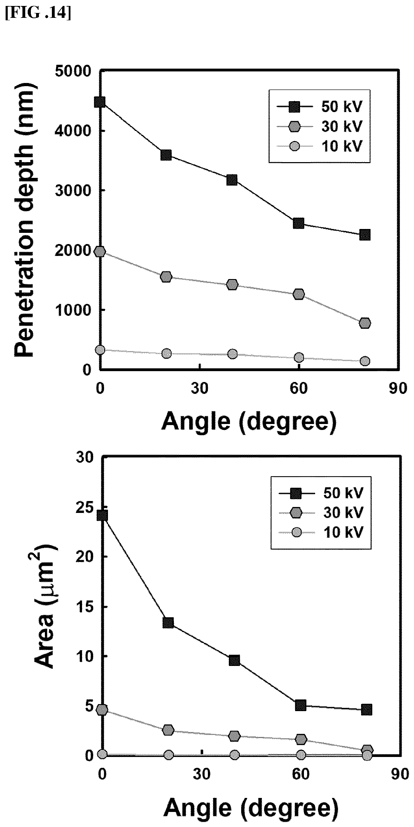

FIG. 12 is a conceptual diagram showing an experiment for identifying an influence of an incident angle of an electron beam on the anode electrode 300. FIGS. 13 and 14 are showing the results of the experiment in FIG. 12.

That is, as illustrated in FIG. 12, various electron beams were emitted, at varying incident angles, to the anode electrode 300 in the shape of a plate. Various values for the influence of the incident angle of the electron beam on the anode electrode 300 were measured. At this point, the measurement values are a penetration depth and a penetration area of the electron beam. That is, the greater the penetration depth and the greater the penetration area, the greater the adverse influence of the electron beam at the corresponding incident angle on the anode electrode 300. As a result, more debris or the like may be generated.

As a result of the measurement, as shown in FIGS. 13 and 14, it can be seen that the penetration depth and the penetration area at the anode electrode 300 vary according to the incident angle of the electron beam. These results of the experiment can be utilized when using the multiplicity of electron beam emission units 200. That is, at least two electron beams emitted from different electron beam emission units 200 can be incident, at different incident angles, on the anode electrode 300, but at different intensities.

Particularly, the results of the experiment show that, overall, the greater the incident angle of the electron beam 300, the smaller the penetration depth and the penetration area. When these results of the experiment are utilized for using the multiplicity of electron beam emission units 200, a first electron beam having a large incident angle can be incident at a higher intensity than a second electron beam having a small incident angle. According to this use, the present disclosure has the advantage of reducing an adverse influence of an electron beam on the anode electrode 300, thereby reducing the generation of debris and lengthening the period for replacement of the anode electrode 300.

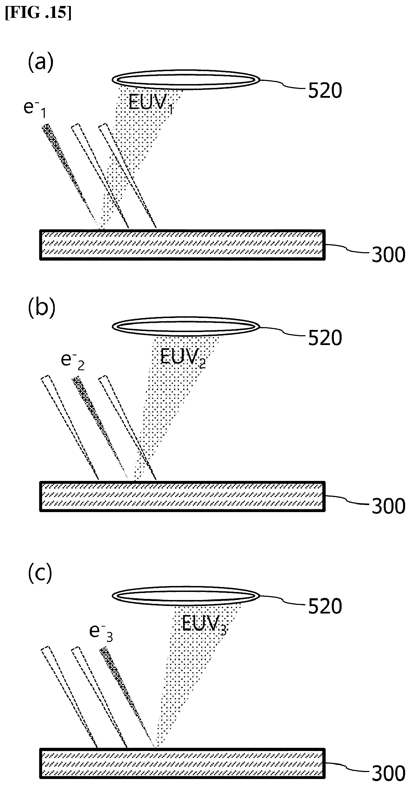

FIGS. 15(a) to 18 are views illustrating various embodiments in cases where light collecting electrodes 520 are provided.

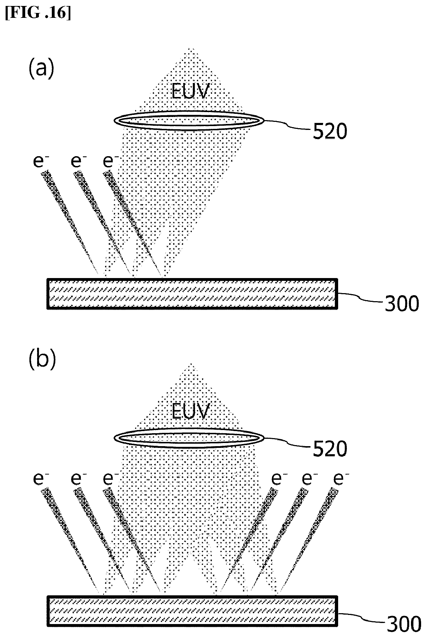

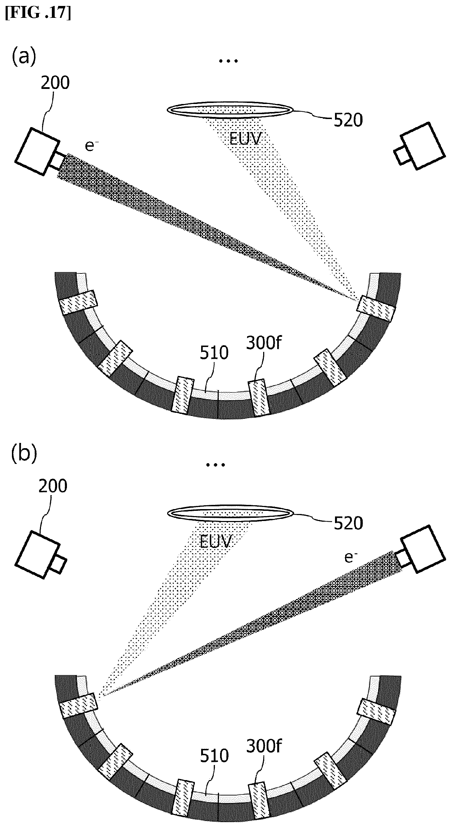

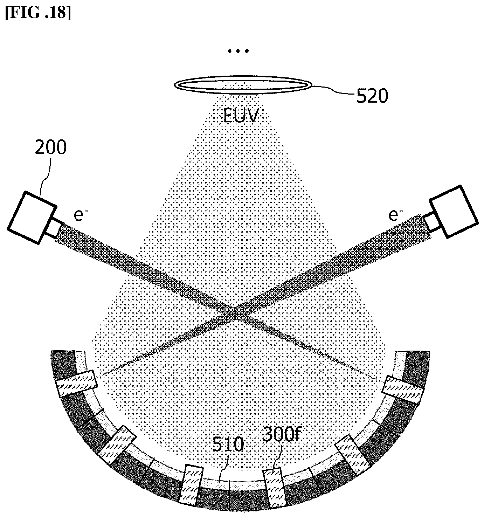

That is, FIGS. 15(a) to 15(c) illustrate a case where the multiplicity of electron beams are incident one by one at various positions on the anode electrode 300 in the shape of a plate. FIGS. 16(a) and 16(b) illustrate cases where the multiplicity of electron beams in FIGS. 15 (a) to (c) are simultaneously incident. In addition, FIGS. 17(a) and 17(b) illustrate a case where the multiplicity of electron beams are incident one by one in a different direction on the anode electrode 300f in the sixth embodiment in FIG. 11. FIG. 18 illustrates a case where the multiplicity of electron beams in FIGS. 17(a) and 17(b) are simultaneously incident. However, for convenience, FIGS. 17(a) and 17(b) and FIG.18 illustrate only two electron beam emission units 200 and two electron beams, and the other electron beam emission units 200 and the other electron beams are omitted.

Meanwhile, with reference to FIGS. 15(a) to 18, the extreme ultraviolet light source device 10 may further include a light collecting electrode 520 arranged within the chamber 100. In this case, the light collecting electrode 520 is an electrode in the shape of a ring that has an opening. The light collecting electrode 520 serves for intermediate focus (IF) of the multiplicity of EUV within the chamber 100, by a specific voltage (for example, a negative or positive voltage) being applied to the light collecting electrode 520. That is, the multiplicity of EUV generated by each of the electron beams emitted from the multiplicity of electron beam emission units 200 pass through an opening in the light collecting electrode 520 to be focused by an electromagnetic repulsive force of the light collecting electrode 520. Each of these electron beams, as illustrated in FIGS. 15(a) to 15(c) and FIGS. 17(a) and 17(b), may be emitted one by one or sequentially according to a drive pulse voltage applied to the gate electrode 240 of the corresponding electron beam emission unit 200. Alternatively, the multiplicity of electron beams, as illustrated in FIGS. 16(a) and 16(b) and FIG. 18, may be simultaneously emitted according to a drive pulse voltage applied to the gate electrode 240 of the corresponding electron beam emission unit 200.

The specific embodiments of the present disclosure are described above, but various modifications may, of course, be made to the specific embodiments within the range that does not depart from the scope of the present disclosure. Therefore, the scope of the present disclosure is not limited to the embodiments which are described above and should be defined by the following claims and equivalents of the claims.

### Industrial Applicability

According to the present disclosure, with the configuration as described above, extreme ultraviolet (EUV) light source is generated based on the electron beams, but using a common anode electrode separately from an electron beam emission unit. Therefore, the present disclosure provides the advantage of achieving a simple inner structure, a compact size, and a low manufacturing cost. In addition, according to the present disclosure, a low-power electron beam can be used when compared with a laser. Therefore, the present disclosure provides not only the advantage of reducing an adverse influence on an anode electrode, reducing debris or the like, and thus facilitating advantageous maintenance of the anode electrode, but also the effect of improving the amount of output of extreme ultraviolet through a plurality of electron beams and through structures of various anode electrodes. In addition, the present disclosure provides the advantage of more efficiently utilizing a multiplicity of electron beams by adjusting their intensities that vary with their respective incident angles.

## Claims

1. A device for outputting extreme ultraviolet light source based on an electron beam, the apparatus comprising:
a chamber;
an electron beam emission unit including a cathode electrode and a plurality of emitters, each of which contains carbon-based material and which are arranged over the cathode electrode in such a manner as to be spaced apart from each other, the electron beam emission unit generating an electron beam within the chamber; and
an anode electrode positioned within the chamber, but in a manner that is spaced apart from the electron beam emission unit, and ionized upon incidence of the electron beam thereon, thereby generating plasma,
wherein extreme ultraviolet is generated from the plasma.

2. The device of claim 1, wherein the anode electrode contains a metal radiative material in a surface thereof, and the metal radiative material generates the plasma.

3. The device of claim 2, wherein the metal radiative material contains one or more selected from the group consisting of Sn, Li, In, Sb, Te, Tb, Gd, and Al.

4. The device of claim 1, wherein a multiplicity of the electron beam emission units are provided, and electron beams generated in the multiplicity of the electron beam emission units are incident at different positions on at least one anode electrode, wherein each of the electron beams is incident one by one or a plurality of the electron beams are incident simultaneously.

5. The device of claim 4, wherein at least two of the electron beams are incident at different angles or in different directions.

6. The device of claim 4, wherein at least two of the electron beams are incident at different angles, but at different intensities.

7. The device of claim 6, wherein a first electron beam having a large incident angle has a higher intensity than a second electron beam having a small incident angle.

8. The device of claim 1, wherein the electron beam emission units are provided in plurality of two or more, the anode electrodes are provided in plurality of two or more, and each of the electron beams generated in the plurality of the electron beam emission units 200 is incident one by one or a plurality of the electron beams are incident simultaneously on the plurality of the anode electrodes.

9. The device of claim 1, further comprising:
a rotation plate rotating within the chamber,
wherein the anode electrode has the shape of a circular plate or a ring and is positioned on the rotation plate, thereby rotating by the rotation plate.

10. The device of claim 9, wherein a multiplicity of the electron beam emission units are provided,
wherein a multiplicity of the anode electrodes having different diameters are provided and are arranged, in the shape of rings, to be spaced apart from each other in the inside thereof, and
wherein each of the electron beams generated in the multiplicity of the electron beam emission units is incident one by one on the multiplicity of the anode electrodes.

11. The device of claim 4, wherein the anode electrode has the shape of a cone or a truncated cone, and each of the electron beams is incident at different positions on a lateral surface of the anode electrode in the shape of a cone or a truncated cone.

12. The device of claim 4, further comprising:
a support body provided within the chamber in such a manner as to support the anode electrode,
wherein a structure including the anode electrode and the support body has the shape of a cone or a truncated cone, and a multiplicity of the anode electrodes are arranged, in the shape of rings, to be spaced apart from each other on a lateral surface of the structure in the shape of a cone or a truncated cone, and
wherein each of the electron beams is incident at different positions on the anode electrodes in the shape of rings.

13. The device of any one of claims 11 and 12, wherein the anode electrode rotates about the central axis of the shape of the cone or the truncated cone.

14. The device of any one of claims 11 and 12, wherein a multiplicity of extreme ultraviolet light source generated by the electron beams proceed in a direction in which the vertex of the anode electrode in the shape of a cone faces straight or proceed in a direction in which an upper surface of the anode electrode in the shape of a truncated cone faces straight.

15. The device of claim 4, wherein a support body in the shape of an arch, which supports the anode electrode, and a reflection layer, which reflects the extreme ultraviolet, are further included within the chamber, and
wherein a multiplicity of the anode electrodes are arranged on the support body along the shape of the arch, in such a manner as to be spaced apart from each other, and the reflection layers are arranged on both sides, respectively, of each anode electrode.

16. The device of claim 4, further comprising:
a light collecting electrode in the shape of a ring provided within the chamber and serving for intermediate focus (IF) of a multiplicity of extreme ultraviolet light source that are generated by each of the electron beams and pass through openings in the light collecting electrode.

17. The device of claim 1, wherein the electron beam emission unit further includes a gate electrode positioned over the plurality of emitters in a manner that is spaced apart from the plurality of emitters, and
wherein a portion, facing the plurality of emitters, of the gate electrode, has a mesh structure of a conductive material.

18. The device of claim 17, wherein the electron beam emission unit further includes at least one focusing electrode positioned over the gate electrode in a manner that is spaced apart from the gate electrode, and focusing the electron beam by a negative voltage being applied to the gate electrode.

19. The device of claim 18, wherein the focusing electrode includes a first focusing electrode and a second focusing electrode arranged over the first focusing electrode in a manner that is spaced apart from the first focusing electrode,
wherein the first and second focusing electrodes have respective openings facing each other, in such a manner as to allow the electron beam to pass through, and
wherein the opening in the second focusing electrode is smaller than the opening in the first focusing electrode.
